# EUROPEAN PATENT APPLICATION

(11) **EP 4 696 481 A1**
(43) Date of publication of application: **18.02.2026**
(21) Application number: 24194646.6
(22) Date of filing: 14.08.2024
(51) Int. Cl.: B29C 45/14, H01R 13/658, B29K 705/02, B29L 31/34, B29K 105/00

(54) **PLASTIC SPLICE WITH EMBOSSED EMC LAYER**

(71) Applicant: Aptiv Technologies AG, 8200 Schaffhausen (CH)
(72) Inventor: CIESZYNSKI, Michal, 8200 Schaffhausen (CH); KWIATKOWSKI, Pawel, 8200 Schaffhausen (CH)
(74) Representative: Bardehle Pagenberg Partnerschaft mbB Patentanwälte Rechtsanwälte

(57) **Abstract**

A method of providing an electrically conductive layer to a plastic housing, in particular a splice housing for electromagnetically shielded cable harnesses, comprises the steps of: a) providing an electrically conductive film and a mould; b) inserting the film in the mould; c) injection moulding plastic into the mould so that the injected plastic bonds with the electrically conductive film.

## Description

### 1. Field of the invention

This invention relates to a method of providing an electrically conductive layer to a plastic housing, and it relates to a splice housing, a cable harness and a vehicle.

### 2. Background

Electromagnetic interference (EMI) can cause significant disruptions in electronic devices and systems, particularly by using plastic housings used in cable harnesses, leading to malfunctions or degradation of performance. To mitigate EMI, housings of electronic components are often made of conductive materials to shield them from external electromagnetic fields.

Traditional methods of providing electromagnetic shielding might include applying conductive coatings or metallic layers to the exterior of plastic housings. However, these methods can be labor-intensive, costly, and subject to wear and degradation over time. Injection moulding conductive materials directly into plastic housings presents a more efficient and durable solution, combining the structural benefits of plastic with the conductive properties necessary for effective EMI shielding.

It is disadvantageously that existing methods often involve multiple steps, including post-moulding applications of conductive coatings, which can be time-consuming and may not provide a robust or long-lasting solution. Additionally, ensuring complete and uniform coverage of conductive material on complex three-dimensional shapes can be challenging with traditional techniques. Thus, there is a demand for improved methods of manufacturing splice housings with EMI shielding.

In view of the foregoing, there is a need for improved methods of manufacturing splice housings with EMI shielding. It is thus an object of the present invention to overcome some or all the deficiencies of the prior art.

### 3. Summary

The above objects are at least partially achieved by the subject matter of independent claim 1. Preferred embodiments are the subject of the dependent claims, and the skilled person will find clues to other suitable aspects of the present invention in the overall disclosure of the present application.

An aspect of the invention relates to a method of providing an electrically conductive layer to a plastic housing, in particular a splice housing for electromagnetically shielded cable harnesses, comprising the steps of a) providing an electrically conductive film and a mould; b) inserting the film in the mould; c) injection moulding plastic into the mould so that the injected plastic bonds with the electrically conductive film.

Such a method could be used to create housings for high-performance automotive cable systems that require electromagnetic interference (EMI) shielding. By integrating the conductive film during the injection moulding process, the resulting plastic housing is both robust and capable of shielding sensitive electronic components from electromagnetic interference. This approach streamlines production, reduces the need for post-processing steps like applying conductive coatings, and ensures a strong bond between the plastic and the conductive layer, enhancing durability and performance.

This method can be improved when the mould has a 3D-contour and the film conforms to the contour during step c) due to the injected plastic.

Such a method can be used to produce complex-shaped housings for electronic devices. The mould is designed with complex 3D contours to match the final product's shape. As the plastic is injected, the conductive film is pressed and molded to fit these contours perfectly. This ensures that the entire surface area of the housing is covered with the conductive layer, providing consistent and effective electromagnetic shielding. The advantage of this approach is the ability to create detailed and precise shapes without compromising the integrity of the conductive layer, leading to higher quality and more reliable electronic housings.

Further improvement is achieved when before step b), the film is preformed to at least partially conform to the contour of the mould.

Such a preforming step can ensure that the film already has the basic shape of the final product, reducing the risk of wrinkles or misalignment during the injection moulding process. The main advantage of preforming the film is improved accuracy and consistency in the final product's conductive layer, leading to better electromagnetic shielding performance and a more aesthetically pleasing finish. Additionally, this method can reduce manufacturing time and costs by minimizing adjustments needed during moulding.

Further improvement is achieved when the film is an in-mould-label.

Such an in-mould label not only provides the required conductive properties but can also include additional information, such as branding or functional graphics. The use of an in-mould label streamlines the production process by combining the labeling and conductive layer application into a single step. This approach enhances the durability of the label, ensuring it remains intact and functional throughout the product's lifecycle. Moreover, it provides a high-quality, finished appearance without the need for additional labeling or printing steps after moulding.

Further improvement is achieved when the film comprises aluminum.

Such a film comprising aluminum can ensure efficient electromagnetic shielding while adding minimal weight to the plastic housing. This is beneficial for applications where weight reduction is important. Additionally, aluminum's durability and resistance to corrosion enhance the longevity and reliability of the product. This method leverages aluminum's properties to produce high-performance, electromagnetically shielded housings with robust and lightweight characteristics.

Further improvement is achieved when the film has a thickness in the range of 0.1 mm to 5 mm, preferably in the range 0.1 mm to 4 mm, more preferably in the range 0.2 mm to 3 mm, most preferably 0.35 mm.

Such a specific thickness of for instance 3.5 mm can provide an optimal balance between flexibility and durability, ensuring that the film can conform to the mould's contours while maintaining its structural integrity and conductivity. A film within this thickness range ensures efficient electromagnetic shielding without adding unnecessary bulk to the plastic housing. This precision in thickness specification allows for enhanced performance and reliability in demanding applications, such as in electronics enclosures and automotive components, where space and weight are important factors.

Further improvement is achieved when after step c) the ratio of the thickness of the plastic layer to the thickness of the electrically conductive film is in the range 1 to 10, preferably in the range 3 to 7, most preferably 5.

According to such a method, after the plastic has been injection molded and bonded to the aluminum conductive film, the thickness of the plastic layer is five times that of the conductive film. Such a specific ratio an ensure that the plastic housing provides adequate mechanical strength and durability while maintaining effective electromagnetic shielding. A ratio of 5 can strike a balance between robust structural support and lightweight design. This optimized ratio helps achieve high performance and reliability in the final product, ensuring that it meets both mechanical and shielding requirements efficiently.

Further improvement is achieved when the film comprises fixation means, adapted to form a form fit connection with the plastic, preferably wherein the fixation means comprises teeth.

Such a type of teeth can be designed to embed into the plastic during the injection moulding process, creating a firm mechanical bond between the film and the plastic. This form fit connection enhances the adhesion between the layers, preventing delamination and ensuring long-term durability. This method is useful in applications where the housing may be subjected to mechanical stress or thermal expansion, such as in automotive environments. The teeth provide additional anchoring points, leading to improved structural integrity and reliability of the final product.

Further improvement is achieved when the film comprises a perforation.

Such a conductive film can be perforated with small holes throughout its surface. These perforations allow the injected plastic to flow through the film, creating a stronger bond between the plastic and the film as it solidifies. The perforations also enhance flexibility, making it easier for the film to conform to complex mould shapes. This method is advantageous for applications requiring a highly durable and flexible conductive layer, such as in complex electronic housings or automotive components. The perforations ensure robust adhesion, preventing separation of the layers under mechanical stress and enhancing the overall durability and performance of the product.

Further improvement is achieved when after step c) the film covers completely the contour of the mould.

Such a conductive film could be designed to entirely cover the 3D contours of the mould. After the injection moulding process, the film forms a continuous layer over the entire surface of the plastic housing. This ensures that the entire housing benefits from the conductive properties of the film, providing comprehensive electromagnetic shielding. Additionally, complete coverage enhances the aesthetic appeal of the final product, providing a uniform surface without gaps or exposed plastic areas. This leads to a more reliable and visually appealing product, meeting both functional and design requirements effectively.

Instead, further improvement could also be achieved, when the film after step c) does not completely cover the contour of the mould.

In such a method, the conductive film can be strategically placed to cover only specific areas of the mould's contour. After the injection moulding process, the film adheres to designated sections of the plastic housing, leaving other areas uncovered. This approach allows for targeted electromagnetic shielding, which is useful in applications where shielding is only needed in certain regions, such as around important electronic components. Additionally, this method can reduce material costs and weight, as less conductive film is used. The selective coverage also provides design flexibility, enabling the creation of housings with varied functional and aesthetic requirements.

Another embodiment of the invention is a splice housing for electromagnetically shielded cable harnesses, comprising two halves formed by a method described precedingly.

Such a splice housing for electromagnetically shielded cable harnesses is made up of two halves created using the described method. Each half could be for instance produced by injection moulding plastic onto an aluminum conductive film. These halves are then joined to encase the cable splices, ensuring complete electromagnetic shielding. The use of the conductive film integrated during moulding provides great protection against electromagnetic interference, enhancing the reliability of the cable harnesses. Additionally, the robust bond between the film and plastic ensures long-lasting durability, making the splice housing suitable for demanding environments in automotive applications. This method allows for precise manufacturing of the splice housing, ensuring a high-quality, effective shield against electromagnetic interference.

Another embodiment of the invention is a cable harness, comprising a splice housing described above.

Such a cable harness incorporates a splice housing made up of two halves created using the specified method. This splice housing provides comprehensive electromagnetic shielding for the cable harness, protecting the enclosed cables from external electromagnetic interference. The use of the conductive film ensures that the housing maintains its shielding effectiveness over time, even in harsh environments. This integration enhances the overall performance and reliability of the cable harness, making it ideal for applications where robust EMC is necessary. Additionally, the precisely manufactured splice housing contributes to the structural integrity and longevity of the cable harness.

Another aspect of the invention is a vehicle, preferably an electric or hybrid vehicle, comprising a cable harness described above.

Such a harness can provide great electromagnetic shielding, protecting the vehicle's sensitive electronic systems from electromagnetic interference. By ensuring reliable operation of the vehicle's electronics, the cable harness enhances overall performance and safety. The advanced shielding is beneficial in electric and hybrid vehicles, where electronic components are important for efficient and effective operation. This integration supports the vehicle's durability and long-term functionality, contributing to a higher-quality, more reliable transportation solution.

Another aspect of the invention is a splice housing for an electromagnetically shielded cable harnesses, the splice housing comprising an outer housing made from injection molded plastic, and an interior conductive film, bonded to the interior walls of the outer housing by the injection molding process.

Such a splice housing for an electromagnetically shielded cable harness includes an outer shell made of injection molded plastic and an interior layer of conductive film. The conductive film is integrated and securely bonded to the inner walls of the plastic shell during the injection molding process. This design provides robust electromagnetic shielding by ensuring the conductive film is firmly attached and covers the necessary areas. The plastic outer shell offers mechanical protection and structural support, while the conductive film prevents electromagnetic interference from affecting the enclosed cables. This construction method results in a durable, reliable splice housing that effectively combines mechanical strength with electromagnetic shielding.

### 4. Brief description of the figures

In the following, preferred embodiments of the disclosure are disclosed by reference to the accompanying figures.
- Fig. 1:: illustrates a splice housing half according to the invention in a perspective view.
- Fig. 2:: shows steps of the injection moulding the film.
- Fig. 3:: depicts a plastic part provided with a conductive film as a fotograph.

### 5. Detailed description of the figures

The subsequent sections provide a detailed description of the invention, referencing the accompanying illustrations for clarity. The descriptions represent examples only and are not intended to limit the invention's scope. Identical reference numerals across the figures and text denote the same components. The illustrations may not reflect actual size or scale; their dimensions, proportions, and depictions of elements might be enhanced for better understanding and visual convenience.

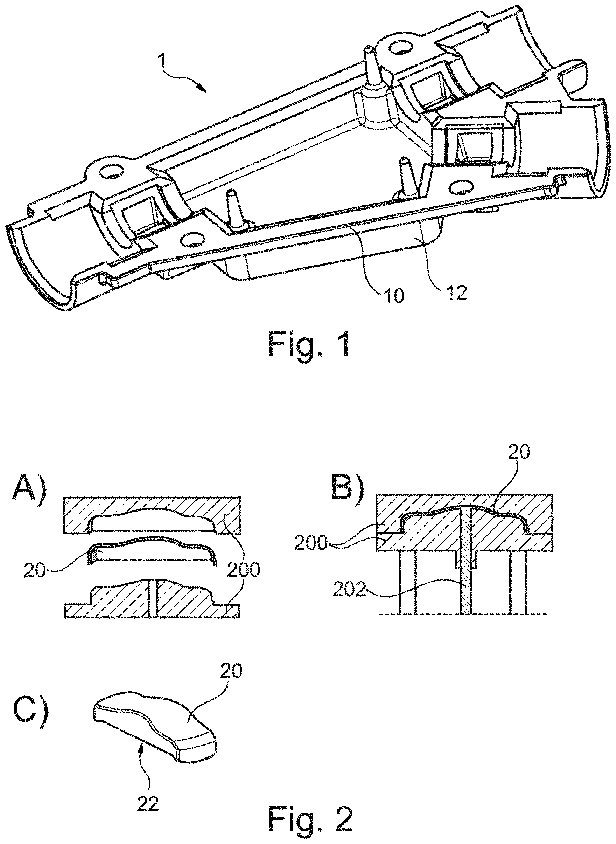

Figure 1 illustrates a half of a splice housing according to the invention. The splice housing half 1 has its inner surface completely covered by the conductive film 10, which adheres to the plastic housing 12, formed by injection moulding. The skilled person will understand that a correspondingly shaped second half may be connected to form a complete splice housing.

The conductive film 10 completely covers the inner surface, thus ensuring full electromagnetic shielding. The bonding of the film to the plastic housing 12 during the injection moulding process can create a strong, durable connection.

Such a continuous integration of the conductive film can enhance the overall performance and reliability of the splice housing. The method also simplifies manufacturing by combining film application and housing formation in a single step.

Figure 2 shows steps of the injection moulding the film. In step A), a pre-formed conductive film 20 is inserted into the mould 200. In step B), the mould 200 is closed and molten plastic 202 is introduced into the mould via injection moulding, thus establishing a bond between the film 20 and the plastic 202. Step C) shows the demoulded housing 22 with a conductive film 20 on its outer side.

With such a process the injection moulding process can ensure precise application and bonding of the conductive film. Step A: Inserting the pre-formed conductive film 20 into the mould 200 can ensures that the film is correctly positioned before plastic injection. Step B: Closing the mould 200 and injecting molten plastic 202 bonds the film 20 to the plastic 202 as it solidifies, creating a strong, uniform layer. Step C: The demoulded housing 22 showcases the conductive film 20 securely attached to its outer side, providing effective electromagnetic shielding. Such a method offers several advantages, including enhanced durability of the bond between the film and the plastic, simplified manufacturing by combining film application and moulding in one step, and the ability to produce complex shapes with an integrated electromagnetic shielding.

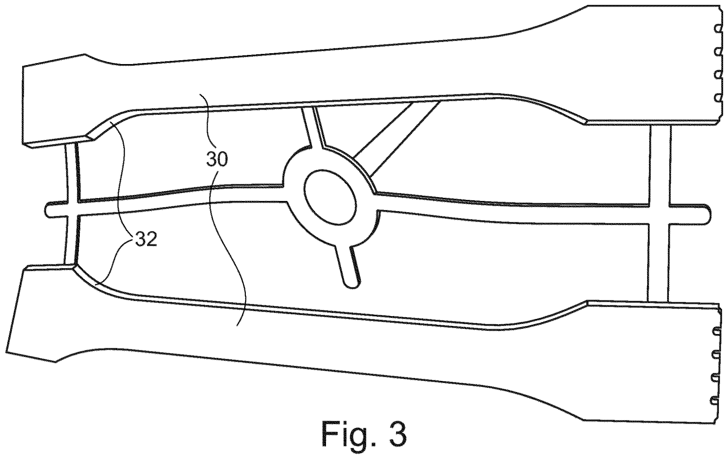

Figure 3 depicts a plastic part provided with a conductive film. The plastic 32 has an adhering conductive film 30.

The figure demonstrates the effectiveness of the bonding process. The plastic part 32 is uniformly covered by the conductive film 30, indicating a strong adhesion between the two materials.

### Reference list:

1: splice housing half
10, 20, 30: conductive film
12, 22: plastic housing
32: plastic
200: mould
202: molten plastic

## Claims

1. A method of providing an electrically conductive layer to a plastic housing, in particular a splice housing for electromagnetically shielded cable harnesses, comprising the steps of:
a) providing an electrically conductive film and a mould;
b) inserting the film in the mould;
c) injection moulding plastic into the mould so that the injected plastic bonds with the electrically conductive film.

2. A method according to claim 1, wherein the mould has a 3D-contour and the film conforms to the contour during step c) due to the injected plastic.

3. A method according to claim 1 or 2, wherein before step b), the film is preformed to at least partially conform to the contour of the mould.

4. A method according to any one of the preceding claims, wherein the film is an in-mould-label.

5. A method according to any one of the preceding claims, wherein the film comprises aluminum.

6. A method according to any one of the preceding claims, wherein the film has a thickness in the range of 0.1 mm to 5 mm, preferably in the range 0.1 mm to 4 mm, more preferably in the range 0.2 mm to 3 mm, most preferably 0.35 mm.

7. A method according to any one of the preceding claims,
wherein after step c) the ratio of the thickness of the plastic layer to the thickness of the electrically conductive film is in the range 1 to 10, preferably in the range 3 to 7, most preferably 5.

8. A method according to any one of the preceding claims,
wherein the film comprises fixation means, adapted to form a form fit connection with the plastic, preferably wherein the fixation means comprises teeth.

9. A method according to any one of the preceding claims, wherein the film comprises a perforation.

10. A method according to any one of the preceding claims, wherein after step c) the film covers completely the contour of the mould.

11. A method according to any one of the claims 1 to 9, wherein the film after step c) does not completely cover the contour of the mould.

12. A splice housing for electromagnetically shielded cable harnesses, comprising two halves formed by a method according to claims 1 to 11.

13. A cable harness, comprising a splice housing according to claim 12.

14. A vehicle, preferably an electric or hybrid vehicle, comprising a cable harness according to claim 13.

15. A splice housing for an electromagnetically shielded cable harnesses, the splice housing comprising an outer housing made from injection molded plastic, and an interior conductive film, bonded to the interior walls of the outer housing by the injection molding process.
